# EUROPÄISCHE PATENTSCHRIFT

(11) **EP 3 618 593 B1**
(45) Veröffentlichungstag und Bekanntmachung des Hinweises auf die Patenterteilung: **16.12.2020**
(21) Anmeldenummer: 19188745.4
(22) Anmeldetag: 29.07.2019
(51) Int. Cl.: H05K 7/14

(54) **VERFAHREN ZUM BEABSTANDETEN VERBINDEN VON LEITERPLATTEN SOWIE MONTAGEEINHEIT UND MONTAGEBAUGRUPPE**
METHOD FOR CONNECTING PRINTED CIRCUIT BOARDS AT DISTANCE AND MOUNTING UNIT AND MOUNTING ASSEMBLY
PROCÉDÉ DE RACCORDEMENT ESPACÉ DES CARTES DE CIRCUIT IMPRIMÉ AINSI QU'UNITÉ DE MONTAGE ET GROUPE DE MONTAGE

(30) Priorität: 30.08.2018 DE 102018214770
(43) Veröffentlichungstag der Anmeldung: 04.03.2020
(73) Patentinhaber: Würth Elektronik eiSos GmbH & Co. KG, 74638 Waldenburg (DE)
(72) Erfinder: Klingler, Stefan, 74544 Michelbach (DE)
(74) Vertreter: Rau, Schneck & Hübner Patentanwälte Rechtsanwälte PartGmbB

(56) Entgegenhaltungen:
- DE-A1-102014 222 951

## Beschreibung

Die vorliegende Patentanmeldung nimmt die Priorität der deutschen Patentanmeldung DE 10 2018 214 770.1 in Anspruch.

Die Erfindung betrifft ein Verfahren zum beabstandeten Verbinden von Leiterplatten. Des Weiteren betrifft die Erfindung eine Montageeinheit und eine Montagebaugruppe für das beabstandete Verbinden von Leiterplatten.

Ein Verfahren zur beabstandeten Verbindung von Leiterplatten und eine hierfür geeignete Befestigungsvorrichtung sind beispielsweise aus der DE 10 2014 222 951 A1 bekannt.

Es ist eine Aufgabe der vorliegenden Erfindung, ein Verfahren zum beabstandeten Verbinden von Leiterplatten zu verbessern, insbesondere flexibler, effizienter und präziser zu gestalten. Diese Aufgabe wird gelöst durch ein Verfahren mit den in Anspruch 1 angegebenen Schritten. Zunächst wird mindestens eine Montageeinheit mit einem eine Aufhahmeöffhung aufweisenden Abstandselement und einem flächigen Abdeckelement, das die Aufnahmeöffnung abdeckt, bereitgestellt. Je Montageeinheit wird zudem ein Befestigungselement bereitgestellt. Weiterhin werden eine erste Leiterplatte und eine mit dieser zu verbindende zweite Leiterplatte bereitgestellt. Das Abstandselement wird an der ersten Leiterplatte positioniert und befestigt. Daraufhin wird das Abdeckelement im Bereich der jeweiligen Aufnahmeöffnung durchbrochen. Das Befestigungselement wird in die Aufnahmeöffnung eingebracht und mit der zweiten Leiterplatte verbunden.

Erfindungsgemäß wurde erkannt, dass das die Aufnahmeöffnung abdeckende Abdeckelement ein einfaches Positionieren und Befestigen des Abstandselements an der ersten Leiterplatte ermöglicht. Die Aufhahmeöffhung behindert die Handhabung und die Montage des Abstandselements nicht. Es ist insbesondere nicht nötig, zunächst das Befestigungselement mit dem Abstandselement zu verbinden. Das Abstandselement wird unabhängig von dem jeweiligen Befestigungselement positioniert und befestigt, was die Flexibilität und Präzision des Verfahrens erhöht. Aufgrund des Durchbrechens des Abdeckelements im Bereich der jeweiligen Aufnahmeöffnung kann das Befestigungselement in die Aufnahmeöffnung eingebracht werden, ohne dass das Abdeckelement entfernt werden muss. Das Abdeckelement behindert das Einbringen des Befestigungselements nicht. Hierdurch ist ein zeitaufwändiges und fehleranfälliges Entfernen des Abdeckelements vermieden. Das Befestigungselement kann auf einfache Weise in die Aufnahmeöffnung eingebracht werden. Das Verfahren ist effizient.

Nach dem Einbringen des Befestigungselements in die Aufnahmeöffnung bilden das Befestigungselement und das Abstandselement eine Befestigungsvorrichtung. Bevorzugt werden das Abstandselement und das Befestigungselement durch das Einbringen des Befestigungselements in die Aufnahmeöffnung formschlüssig verbunden, wodurch eine stabile Befestigungsvorrichtung geschaffen ist. Für die beabstandete Verbindung der Leiterplatten reicht eine einzelne Befestigungsvorrichtung aus. Bevorzugt werden jedoch mehrere Befestigungsvorrichtungen mit jeweils einem Abstandselement und jeweils einem Befestigungselement verwendet. Die hierfür nötigen Verfahrensschritte sind für jede Befestigungsvorrichtung bzw. die jeweiligen Montageeinheit sowie das zugehörige Befestigungselement gleich und sind unabhängig von weiteren Befestigungsvorrichtungen durchführbar. Im Folgenden werden die Verfahrensschritte daher nur für eine einzelne Montageeinheit und das zugehörige Befestigungselement beschrieben.

Das Abdeckelement ist flächig ausgebildet. Dies bedeutet, dass sich das Abdeckelement in einer Ebene erstreckt und in der Ebene eine Ausdehnung hat, die eine Dicke des Abdeckelements senkrecht zu der Ebene um ein Vielfaches übersteigt. Das flächige Abdeckelement deckt die Aufnahmeöffnung zumindest teilweise, bevorzugt vollständig, ab. Hierdurch ist die Aufnahmeöffnung insbesondere zumindest an einer Seite verschlossen, insbesondere dicht verschlossen. Die Aufnahmeöffnung behindert weder die Handhabung und das Positionieren noch das Befestigen des Abstandselements.

Das Abstandselement weist bevorzugt eine Haupterstreckung entlang einer Mittellängsachse auf. Dies bedeutet, dass ein Querschnitt des Abstandselements senkrecht zu der Mittellängsachse kleiner ist als dessen Länge entlang der Mittellängsachse. Die Aufnahmeöffnung ist gegebenenfalls bevorzugt an einer Stirnseite des Abstandselements ausgebildet. Besonders bevorzugt liegt die Aufnahmeöffnung einem Ende des Abstandselements, das an der ersten Leiterplatte befestigt wird, gegenüber. Das Abstandselement kann im Wesentlichen zylindrisch, insbesondere kreiszylindrisch um die Mittellängsachse ausgeführt sein. Das Abstandselement kann in unterschiedlichen Längen bereitgestellt werden, um je nach Bedarf eine unterschiedliche Beabstandung der zu verbindenden Leiterplatten zu ermöglichen.

Das Abstandselement kann einen Einführabschnitt aufweisen, der in eine entsprechende Bohrung der ersten Leiterplatte einführbar ist. Hierdurch ist ein einfaches, genaues und zuverlässiges Positionieren und Befestigen des Abstandselements an der ersten Leiterplatte gewährleistet.

Die Aufnahmeöffnung kann als Durchgangsbohrung entlang der Mittellängsachse des Abstandselements ausgeführt sein. Alternativ kann die Aufnahmeöffnung auch als Sacklochbohrung ausgeführt sein.

Das Befestigungselement weist bevorzugt eine Haupterstreckung entlang einer Mittellängsachse auf. Besonders bevorzugt weisen das Abstandselement und das Befestigungselement entsprechende Mittellängsachsen auf, die nach dem Verbinden dieser Elemente zu der Befestigungsvorrichtung eine gemeinsame Mittellängsachse der Befestigungsvorrichtung bilden.

Das Befestigungselement weist bevorzugt einen ersten Befestigungsabschnitt zum Einbringen in die Aufnahmeöffnung und/oder einen zweiten Befestigungsabschnitt zum Verbinden mit der zweiten Leiterplatte auf. Der erste Befestigungsabschnitt und der zweite Befestigungsabschnitt können an entlang der Mittellängsachse des Befestigungselements gegenüberliegenden Enden des Befestigungselements angeordnet sein.

Der zweite Befestigungsabschnitt ist beispielsweise als Rastvorrichtung ausgebildet, die zum Verbinden des zweiten Befestigungsabschnitts mit der zweiten Leiterplatte in eine entsprechende Bohrung der zweiten Leiterplatte einführbar ist und dort verrastet. Alternativ kann der zweite Befestigungsabschnitt als Haltevorrichtung, beispielsweise als Schraubenkopf, ausgeführt sein, der die zweite Leiterplatte an einer Haltefläche, beispielsweise gegen die Stirnseite des Abstandselements, hält.

Der erste Befestigungsabschnitt ist bevorzugt korrespondierend zu der Aufnahmeöffnung ausgebildet. Durch Einbringen des ersten Befestigungsabschnitts in die Aufnahmeöffnung ist insbesondere eine formschlüssige Verbindung des Befestigungselements mit dem Abstandselement möglich. Die Aufnahmeöffnung kann insbesondere zum Verrasten, Verschrauben oder Einpressen des ersten Befestigungsabschnitts in derselben ausgebildet sein. Beispielsweise kann die Aufnahmeöffnung ein Innengewinde aufweisen. Gegebenenfalls kann der erste Befestigungsabschnitt als Schraube mit einem dem Innengewinde der Aufnahmeöffnung entsprechenden Außengewinde ausgeführt sein. Alternativ ist es möglich, den ersten Befestigungsabschnitt als Tragzapfen mit Tragzapfen-Rastvorsprüngen auszubilden, die beispielsweise an ein Innengewinde der Aufnahmeöffnung angepasst sind.

Das Befestigungselement ist bevorzugt einstückig. Das Befestigungselement ist dadurch kostengünstig fertigbar und stabil. In einem besonders praktikablen Ausführungsbeispiel ist das Befestigungselement als Schraube ausgeführt. Gegebenenfalls kann das Schraubengewinde als erster Befestigungsabschnitt in der Aufnahmeöffnung verschraubt werden. Der Schraubenkopf kann als zweiter Befestigungsabschnitt dienen, der die zweite Leiterplatte hält, insbesondere gegen das Abstandselement hält.

Beispielsweise kann das Befestigungselement einstückig aus Kunststoffmaterial gefertigt sein. Das Kunststoffmaterial isoliert die miteinander verbundenen Leiterplatten elektrisch. Zudem ist eine einfache und integrale Ausführung von Rastelementen für den ersten Befestigungsabschnitt sowie den zweiten Befestigungsabschnitt möglich. Alternativ kann das Befestigungselement auch aus einem Metall gefertigt sein. In diesem Fall kann das Befestigungselement, insbesondere dessen zweiter Befestigungsabschnitt, mit der Leiterplatte verlötet werden. Zusätzlich oder alternativ ist ein Verlöten des Befestigungselements, insbesondere dessen ersten Befestigungsabschnitts, mit dem Abstandselement möglich.

Das Durchbrechen des Abdeckelements kann beispielsweise mechanisch oder pneumatisch erfolgen. Insbesondere kann das Abdeckelement mit einer Perforiervorrichtung, beispielsweise einem Dorn, durchstochen werden. Alternativ kann das Durchbrechen mit einem Luftdruckstrahl erfolgen. Nach dem Durchbrechen des Abdeckelements ist die Aufüahmeöffnung zumindest weitestgehend freigegeben, sodass der erste Befestigungsabschnitt des Befestigungselements eingebracht werden kann.

Ein Verfahren nach Anspruch 2 ist effizient und kostengünstig. Wird das Abdeckelement im Bereich der Aufüahmeöffnung durch das Befestigungselement, insbesondere dessen ersten Befestigungsabschnitt durchbrochen, kann auf eine zusätzliche Perforiervorrichtung verzichtet werden. Das Durchbrechen des Abdeckelements erfolgt besonders bevorzugt beim Einbringen des Befestigungselements, insbesondere des ersten Befestigungsabschnitts in die Aufnahmeöffnung. Ein zusätzlicher Verfahrensschritt für das Durchbrechen des Abdeckelements ist dann nicht nötig. Ein weiterer Vorteil des Durchbrechens des Abdeckelements beim Einbringen des Befestigungselements, insbesondere des ersten Befestigungsabschnitts ist, dass Bruchstücke bzw. Fragmente, die beim Durchbrechen des Abdeckelements entstehen, in die Aufüahmeöffnung gedrückt werden und dort gehalten werden können. Ein unkontrolliertes Ablösen der Bruchstücke und/oder Fragmente des Abdeckelements ist vermieden.

Ein Verfahren nach Anspruch 3 ist flexibel und genau. Das Halten der Montageeinheit mit Hilfe einer Montagevorrichtung an dem Abdeckelement erlaubt eine einfache maschinelle Handhabung und Positionierung der Montageeinheit. Beispielsweise kann das Abdeckelement magnetisch sein, insbesondere magnetische Partikel aufweisen, sodass ein magnetisches Halten der Montageeinheit an dem Abdeckelement möglich ist. Bevorzugt jedoch dient das Abdeckelement als Ansaugelement, besonders bevorzugt als Ansaugfolie, sodass die Montageeinheit pneumatisch gehalten werden kann. Hierbei wird durch die Montagevorrichtung mittels Ansaugung ein Unterdruck erzeugt. Das Abdeckelement stellt sicher, dass der Unterdruck zwischen der Montagevorrichtung und der Montageeinheit erzeugt werden kann und kein Druckausgleich über die Aufnahmeöffnung erfolgt. Falls das Abdeckelement die Aufnahmeöffnung nicht fluiddicht abdeckt, können geringe Leckströme entstehen. Diese auch als Falschluft bezeichneten Leckströme können jedoch durch eine entsprechende Anpassung der Ansaugung ausgeglichen werden und sind daher tolerierbar. Geringe Leckströme können beispielsweise auftreten, wenn das Abdeckelement eine Perforierung aufweist.

Ein Verfahren nach Anspruch 4 ermöglicht eine stabile Verbindung des Abstandselements mit der ersten Leiterplatte. Zum Verlöten des Abstandselements mit der ersten Leiterplatte ist das Abstandselement bevorzugt insgesamt aus lötfähigem Material, besonders bevorzugt einstückig aus Metall, gefertigt. Dies erhöht die Stabilität des Abstandselements und damit der Verbindung mit der Leiterplatte.

Ein Verfahren nach Anspruch 5 ist besonders präzise und effizient. Das innerhalb des im Bereich der Aufnahmeöffnung gemessenen Querschnitts des Abstandselements liegende Abdeckelement steht nicht über den Querschnitt des Abstandselements über. Insbesondere weist das Abdeckelement keine Abreißfahne auf. Der Querschnitt der Montageeinheit ist daher durch den Querschnitt des Abstandselements begrenzt. Das Abdeckelement blockiert eine insbesondere visuelle Kontrolle bei und/oder nach der Positionierung und/oder Befestigung nicht. Das Abstandselement kann mit einer erhöhten Genauigkeit positioniert und befestigt werden. Die Fehlerquote und damit der Ausschuss sind verringert. Ein weiterer Vorteil besteht darin, dass der Querschnitt der Montageeinheit nicht durch das Abdeckelement vergrößert wird. Hierdurch ist eine dichtere Positionierung mehrerer Montageeinheiten auf der ersten Leiterplatte möglich.

Das Abstandselement ist insbesondere im Wesentlichen zylindrisch um die Mittellängsachse ausgeführt. Die Querschnittsfläche des Abstandselements ist gegebenenfalls die Grundfläche des Zylinders. Bevorzugt ist das Abstandselement im Wesentlichen kreiszylindrisch um die Mittellängsachse ausgeführt, sodass die Querschnittsfläche des Abstandselements kreisförmig ist. In diesem Fall kann eine maximale Ausdehnung des Abdeckelements zwischen 70 % und 100 %, insbesondere zwischen 85 % und 95 % des Durchmessers des kreisförmigen Querschnitts betragen. Besonders bevorzugt ist auch das Abdeckelement kreisförmig mit einem der maximalen Ausdehnung entsprechenden Durchmesser ausgeführt. Dies gewährleistet, dass das Abdeckelement nicht über die Querschnittsfläche des Abstandselements übersteht und gleichzeitig die Aufnahmeöffnung vollständig abdeckt.

Ein Verfahren nach Anspruch 6 ist effizient und kostengünstig. Das Abdeckelement kann auf einfache Weise auf das Abstandselement aufgebracht, insbesondere aufgeklebt werden. Entsprechende Folien, insbesondere Klebefolien sind kostengünstig. Besonders bevorzugt werden Polyimid-Folien verwendet. Als Folien ausgeführte Abdeckelemente haben weiterhin den Vorteil, dass diese leicht durchbrochen bzw. durchstoßen werden können. Hierdurch ist das Verfahren vereinfacht.

Das Abdeckelement, insbesondere ein als Folie ausgestaltetes Abdeckelement, kann beispielsweise eine Dicke zwischen 0,03 mm und 1 mm, insbesondere zwischen 0,05 mm und 0,5 mm aufweisen. Die Dicke des Abdeckelements kann sich aus einer Folienstärke und der Dicke einer Klebstoffschicht zusammensetzen. Eine beispielhafte Folienstärke beträgt zwischen 0,03 mm und 0,35 mm, insbesondere zwischen 0,03 mm und 0,1 mm. Die Dicke einer Klebstoffschicht kann zwischen 0,02 mm und 0,1 mm, insbesondere zwischen 0,04 mm und 0,075 mm betragen. Ein beispielhaftes Abdeckelement kann eine Folienstärke von 0,03 mm und eine Klebstoffschicht von 0,04 mm aufweisen. Abdeckelemente geringer Dicke können leicht durchbrochen bzw. durchstoßen werden.

Ein Verfahren gemäß Anspruch 7 ermöglicht ein einfaches Durchbrechen des Abdeckelements. Die mindestens eine Sollbruchstelle im Bereich der Aufnahmeöffnung kann durch eine Materialschwächung, beispielsweise durch Materialabtrag oder das Einbringen von Kerben und/oder einer Perforierung, ausgebildet sein. Alternativ kann die Sollbruchstelle auch durch Spannungen innerhalb des Abdeckelements realisiert sein. Mit einer Sollbruchstelle versehene Abdeckelemente können einfach durchstoßen bzw. durchbrochen werden. Insbesondere kann das Durchbrechen des Abdeckelements mit Hilfe des ersten Befestigungsabschnitts des Befestigungselements erfolgen. Eine Perforiervorrichtung ist für das Durchbrechen des Abdeckelements nicht nötig.

Die Sollbruchstelle kann beispielsweise durch bereichsweise unterschiedliche Dicken des Abdeckelements, insbesondere durch unterschiedliche Folienstärken eines als Folie ausgebildeten Abdeckelements, ausgebildet sein. Unterschiedliche Dicken können beispielsweise durch Materialabtrag mit Hilfe eines Lasers und/oder durch Ätzen erzielt werden.

Falls die Sollbruchstelle eine Perforierung des Abdeckelements aufweist, können beim pneumatischen Halten geringe Leckströme auftreten, die jedoch korrigierbar sind. Durch eine alternative Ausführung der Sollbruchstelle, bei der das Abdeckelement auch im Bereich der Sollbruchstelle keine Durchgangsöffnungen aufweist, kann das Halten, insbesondere das pneumatische Halten, der Montageeinheit am Abdeckelement weiter vereinfacht und verbessert werden.

Die Kerbung und/oder die Perforierung sind besonders effektiv und kostengünstig. Bevorzugt ist die mindestens eine Sollbruchstelle nur durch die mindestens eine Kerbung und/oder Perforierung realisiert. Die Kerbung und/oder Perforierung kann auf einfache Weise durch Einstechen, Ritzen und/oder Einprägen in das Abdeckelement eingebracht werden. Ein Materialabtrag ist nicht nötig. Die Kerbung und/oder Perforierung verläuft vorzugsweise ausgehend von einem Mittelpunkt radial.

Ein Verfahren nach Anspruch 8 ist zuverlässig und kostengünstig. Der Kontrollschritt gewährleistet, dass fehlerhaft positionierte und/oder befestigte Abstandselemente frühzeitig identifiziert werden können. Gegebenenfalls können fehlerhaft positionierte Abstandselemente entfernt und/oder ersetzt werden. Hierdurch ist der Ausschuss des Verfahrens verringert. Der Kontrollschritt zur Kontrolle der Positionierung und/oder Befestigung ist besonders zuverlässig, wenn das Abdeckelement nicht über die Querschnittsfläche des Abstandselements übersteht, wie dies weiter oben beschrieben wurde. Hierdurch ist eine genaue Kontrolle, insbesondere visuelle Kontrolle der Positionierung und/oder Befestigung möglich.

Es ist eine weitere Aufgabe der Erfindung, eine verbesserte Montageeinheit für das beabstandete Verbinden zweier Leiterplatten bereitzustellen.

Diese Aufgabe wird gelöst durch eine Montageeinheit mit den in Anspruch 9 angegebenen Merkmalen. Die Montageeinheit weist ein Abstandselement mit einer Aufnahmeöffnung zur Aufnahme eines Befestigungselements, insbesondere eines ersten Befestigungsabschnitts des Befestigungselements, auf. Ein flächiges Abdeckelement deckt die Aufnahmeöffnung ab. Hierdurch ist die Handhabung der Montageeinheit verbessert. Insbesondere kann die Montageeinheit trotz der Aufnahmeöffnung des Abstandselements an der flächigen Oberseite des Abdeckelements gehalten, insbesondere pneumatisch gehalten werden. Die Montageeinheit ist in dem oben beschriebenen Verfahren einsetzbar. Die Vorteile der Montageeinheit entsprechen den Vorteilen des Verfahrens.

Eine Montageeinheit nach Anspruch 10 ist kostengünstig und einfach herstellbar sowie flexibel einsetzbar. Das als Folie ausgebildete Abdeckelement kann auf einfache Weise auf dem Abstandselement aufgebracht, insbesondere aufgeklebt werden. Besonders bevorzugt ist das Abdeckelement eine Polyimid-Folie.

Eine Montageeinheit nach Anspruch 11 ist besonders flexibel einsetzbar. Die geringe Dicke des Abdeckelements erlaubt ein einfaches Durchbrechen des Abdeckelements. Insbesondere kann das Abdeckelement beim Einführen des ersten Befestigungsabschnitts des Befestigungselements in die Aufnahmeöffnung durchbrochen werden. Die Dicke eines als Folie, insbesondere Klebefolie ausgebildeten Abdeckelements kann sich aus der Dicke einer Klebstoffschicht einer Folienstärke zusammensetzen wie dies oben in Bezug auf das Verfahren beschrieben ist.

Das Abdeckelement einer Montageeinheit nach Anspruch 12 kann besonders einfach durchbrochen werden. Eine Perforiervorrichtung zum Durchbrechen des Abdeckelements ist nicht nötig. Bezüglich der weiteren Vorteile und Ausgestaltungen der Sollbruchstelle wird auf die obigen Ausführungen zum Verfahren verwiesen.

Eine Montageeinheit mit einer Kerbung und/oder Perforierung ist einfach fertigbar und kostengünstig. Die Kerbung und/oder Perforierung kann auf einfache Weise in das Abdeckelement eingebracht werden.

Vorzugsweise weist die Montageeinheit eine Mehrzahl von Sollbruchstellen auf. Dies gewährleistet eine hohe Zuverlässigkeit und Sicherheit. Durch eine Mehrzahl von Sollbruchstellen ist das Bruchverhalten des Abdeckelements präzise steuerbar. Bruchstücke bzw. Fragmente des Abdeckelements sind hierdurch in ihrer Größe und Verteilung einstellbar. Insbesondere ist gewährleistet, dass die Bruchstücke und/oder Fragmente des Abdeckelements sich nicht vollständig ablösen, sondern mit dem Abdeckelement verbunden bleiben. Besonders bevorzugt können die Bruchstücke bzw. Fragmente an die Innenseite der Aufnahmeöffnung gedrückt werden, ohne das Einbringen des ersten Befestigungsabschnitts des Befestigungselements zu behindern. Eine Mehrzahl von Sollbruchstellen vereinfacht zudem nochmals das Durchbrechen des Abdeckelements. Besonders bevorzugt sind die Sollbruchstellen jeweils als Kerbung und/oder Perforierung ausgebildet, insbesondere in das Abdeckelement eingeritzt, eingestochen oder eingeprägt.

Die mehreren Sollbruchstellen sind bevorzugt der Form des Abdeckelements entsprechend, insbesondere symmetrisch angeordnet. Insbesondere bei einem kreisförmigen Abdeckelement können die Sollbruchstellen beispielsweise sternförmig von einem Mittelpunkt des Abdeckelements ausgehend angeordnet sein. Alternativ können die Sollbruchstellen in Form eines Gitters, insbesondere eines Rechteckgitters, in das Abdeckelement angeordnet sein. Wiederum alternativ können die Sollbruchstellen der Form der Aufnahmeöffnung entsprechen. Bei einer Aufnahmeöffnung mit kreisförmigen Querschnitt, können die Sollbruchstellen beispielsweise entlang einer dem Querschnitt der Aufnahmeöffnung entsprechenden Kreislinie angeordnet sein. Zusätzlich hierzu können radial vom Mittelpunkt des Kreises ausgehende Sollbruchstellen vorhanden sein. Diese radial angeordneten Sollbruchstellen können den von der Kreislinie beschriebenen Kreis bevorzugt in gleichmäßige Kreissektoren aufteilen, insbesondere in zwei, drei, vier oder mehr Kreissektoren aufteilen.

Eine Montageeinheit nach Anspruch 13 erlaubt eine präzise Positionierung und Befestigung des Abdeckelements an einer Leiterplatte. Das Abdeckelement steht nicht über die im Bereich der Aufnahmeöffnung gemessene Querschnittsfläche des Abstandselements über. Das Abdeckelement behindert somit nicht eine insbesondere visuelle Kontrolle bei und/oder nach der Positionierung und Befestigung des Abstandselements an der Leiterplatte. Zudem können mehrere Montageeinheiten dicht beieinander auf der Leiterplatte positioniert werden.

Eine Montageeinheit nach Anspruch 14 ist stabil. Insbesondere eignet sich das Abstandselement dazu, mit der Leiterplatte verlötet zu werden. Hierdurch wird auch die Verbindung des Abstandselements mit der Leiterplatte verbessert. Ein metallisches Abstandselement verbessert zudem die Wärmeabfuhr von der Leiterplatte. Besonders bevorzugt ist das Abstandselement aus Stahl, A2-Edelstahl, Messing und/oder Aluminium gefertigt.

Es ist eine weitere Aufgabe der Erfindung eine verbesserte Montagebaugruppe für das beabstandete Verbinden zweier Leiterplatten bereitzustellen.

Diese Aufgabe wird gelöst durch eine Montagebaugruppe mit den in Anspruch 15 angegebenen Merkmalen. Die Montagebaugruppe umfasst eine Montageeinheit und ein Befestigungselement. Die Montageeinheit weist ein Abstandselement mit einer Aufnahmeöffnung und ein flächiges Abdeckelement, das die Aufnahmeöffnung abdeckt, auf. Das Befestigungselement weist insbesondere einen zu der Aufnahmeöffnung des Abstandselements korrespondierenden ersten Befestigungsabschnitt und einen zweiten Befestigungsabschnitt auf. Die Montageeinheit und das Befestigungselement sind getrennt voneinander. Sie können durch Einbringen des Befestigungselements, insbesondere dessen ersten Befestigungsabschnitts, in die Aufnahmeöffnung zu einer Befestigungsvorrichtung verbunden werden. Die Montagebaugruppe eignet sich für die Durchführung des oben beschriebenen Verfahrens. Die weiteren Eigenschaften und Vorteile der Montagebaugruppe entsprechen denen, die vorstehend in Bezug auf das Verfahren und auf die Montageeinheit bereits beschrieben wurden.

Weitere Merkmale, Vorteile und Einzelheiten der Erfindung ergeben sich aus der nachfolgenden Beschreibung mehrerer Ausführungsbeispiele. Es zeigen:
- Fig. 1: einen Schnitt durch eine Befestigungsvorrichtung, die zwei Leiterplatten beabstandet miteinander verbindet,
- Fig. 2: eine perspektivische Ansicht einer Montageeinheit für das beabstandete Verbinden von Leiterplatten,
- Fig. 3: eine perspektivische Ansicht eines Abstandselements der Montageinheit gemäß Fig. 2,
- Fig. 4: eine perspektivische Ansicht eines Abdeckelements der Montageeinheit gemäß Fig. 2,
- Fig. 5: ein schematischer Verfahrensablauf eines Verfahrens zum beabstandeten Verbinden von Leiterplatten,
- Fig. 6: eine perspektivische Ansicht eines alternativen Ausführungsbeispiels eines Abdeckelements für eine Montageinheit,
- Fig. 7: eine Aufsicht auf ein weiteres alternatives Ausführungsbeispiel eines Abdeckelements für eine Montageeinheit,
- Fig. 8: eine Aufsicht auf ein weiteres alternatives Ausführungsbeispiel eines Abdeckelements für eine Montageeinheit, und
- Fig. 9: einen Schnitt durch ein alternatives Ausführungsbeispiel einer Befestigungsvorrichtung, die zwei Leiterplatten beabstandet miteinander verbindet.

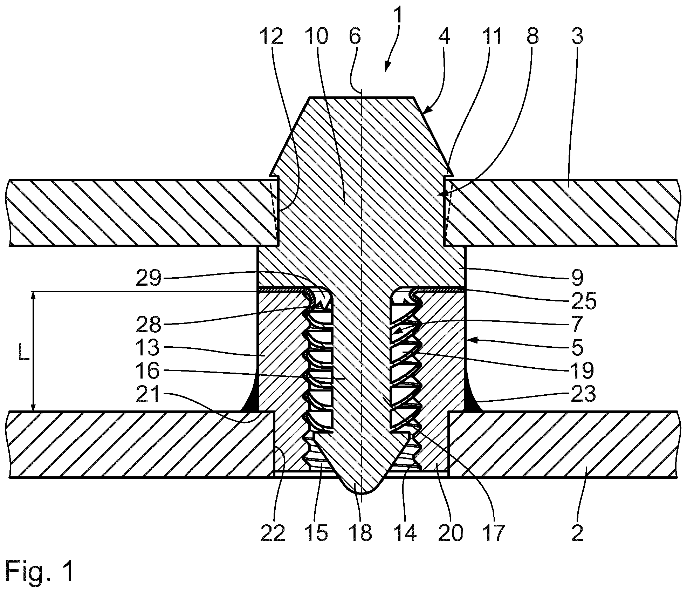

In Fig. 1 ist ein Schnitt durch eine Befestigungsvorrichtung 1 gezeigt, über die eine erste Leiterplatte 2 beabstandet mit einer zweiten Leiterplatte 3 verbunden ist. Die Befestigungsvorrichtung 1 umfasst ein Befestigungselement 4 und ein Abstandselement 5. Das Befestigungselement 4 und das Abstandselement 5 sind formschlüssig zu der Befestigungsvorrichtung 1 verbunden. Das Befestigungselement 4 und das Abstandselement 5 weisen jeweils eine Mittellängsachse 6 auf, die parallel verlaufen und eine entsprechende Mittellängsachse 6 der Befestigungsvorrichtung 1 definieren. Die Leiterplatten 2, 3 erstrecken sich parallel zueinander in Ebenen, die senkrecht zu der Mittellängsachse 6 verlaufen. Die Leiterplatten 2, 3 sind durch die Befestigungsvorrichtung 1 daher in Richtung der Mittellängsachse 6 voneinander beabstandet.

Das Befestigungselement 4 weist einen ersten Befestigungsabschnitt 7 und einen dem ersten Befestigungsabschnitt 7 in Richtung der Mittellängsachse 6 gegenüberliegenden zweiten Befestigungsabschnitt 8 auf. Zwischen den Befestigungsabschnitten 7, 8 des Befestigungselements 4 ist ein Mittelabschnitt 9 angeordnet. Das Befestigungselement 4 ist einstückig aus Kunststoffmaterial ausgebildet.

Das Mittelelement 9 ist kreisscheibenförmig um die Mittellängsachse 6 ausgebildet. Der zweite Befestigungsabschnitt 8 erstreckt sich ausgehend von dem Mittelabschnitt 9 konzentrisch zu der Mittellängsachse 6. Der zweite Befestigungsabschnitt 8 weist einen zylinderförmigen Grundkörper 10 auf, dessen Radius gegenüber dem Mittelabschnitt 9 verjüngt ist. An dem den Mittelabschnitt 9 gegenüberliegendem Ende des zylinderförmigen Grundkörpers 10 ist ein konzentrisch um die Mittellängsachse 6 verlaufender Rastvorsprung 11 vorhanden, der radial über den zylinderförmigen Grundkörper 10 übersteht. Der Rastvorsprung 11 ist elastisch ausgeführt. Die Leiterplatte 3 weist eine kreisförmige Öffnung 12 auf, deren Durchmesser an den Durchmesser des zylinderförmigen Grundkörpers 10 angepasst ist. Die Rastvorsprünge 11 sind widerhakenförmig ausgestaltet, sodass die Leiterplatte 3 von oben über die Rastvorsprünge 11 geführt werden kann und im Bereich des zylinderförmigen Grundkörpers 10 zwischen den Rastvorsprüngen 11 und dem Mittelabschnitt 9 gehalten wird. Der zweite Befestigungsabschnitt 8 ist daher als Rastvorrichtung ausgeführt, die mit der zweiten Leiterplatte 3 verrastet ist. In anderen, nicht gezeigten Ausführungsbeispielen ist das Befestigungselement, insbesondere der zweite Befestigungsabschnitt anders ausgeführt. Bezüglich alternativer Ausführungsbeispiele des Befestigungselements, insbesondere des zweiten Befestigungsabschnitts zum Befestigen der zweiten Leiterplatte 3, wird auf die DE 10 2014 222 951 A1 verwiesen.

Das Abstandselement 5 ist einstückig aus Metall gefertigt. Das Abstandselement 5 ist im Wesentlichen als kreiszylindrischer Hülsenkörper 13 konzentrisch um die Mittellängsachse 6 ausgeführt. Der Hülsenkörper 13 weist eine Länge L in Richtung der Mittellängsachse 6 auf. In dem Abstandselement 5 ist eine sich entlang der Mittellängsachse 6 erstreckende Aufnahmeöffnung 14 ausgebildet. Die Aufnahmeöffnung 14 ist konzentrisch zu der Mittellängsachse und erstreckt sich als Durchgangsbohrung über das gesamte Abstandselement 5 in Richtung der Mittellängsachse 6. In der Aufnahmeöffnung 14 ist ein Innengewinde 15 ausgebildet.

Der erste Befestigungsabschnitt 7 ist an der dem zweiten Befestigungsabschnitt 8 gegenüberliegenden Seite des Mittelabschnitts 9 angeordnet. Der erste Befestigungsabschnitt 7 ist korrespondierend zu der Aufnahmeöffnung 14 und dem Innengewinde 15 ausgebildet. Der erste Befestigungsabschnitt 7 weist einen sich entlang der Mittellängsachse 6 erstreckenden Tragzapfen 16 auf. Der Tragzapfen 16 weist einen zylindrischen Tragzapfen-Grundkörper 17 und eine dem Mittelabschnitt 9 abgewandte Tragzapfen-Spitze 18 auf. Die Tragzapfen-Spitze 18 verjüngt sich zum freien Ende des Tragzapfens 16 hin. An dem Tragzapfen-Grundkörper 17 sind Tragzapfen-Rastvorsprünge 19 ausgebildet, die korrespondierend zu dem Innengewinde 15 ausgeformt sind. Die Tragzapfen-Rastvorsprünge 19 sind tellerförmig ausgebildet und greifen in das Innengewinde 15 ein. Hierdurch verrastet der erste Befestigungsabschnitt 7 in der Aufnahmeöffnung 14, sodass eine formschlüssige Verbindung zwischen dem Befestigungselement 4 und dem Abstandselement 5 geschaffen ist.

An seinem dem Befestigungselement 4 abgewandten Ende weist das Abstandselement 5 einen ringförmigen Einführabschnitt 20 auf. Der Einführabschnitt 20 ist gegenüber dem Hülsenkörper 13 verjüngt, sodass ein Leiterplattenanschlag 21 am Übergang von den Hülsenkörper 13 zu dem Einführabschnitt 20 ausgebildet ist. Der Einführabschnitt 20 ist in eine entsprechende Aufnahmebohrung 22 der ersten Leiterplatte 2 eingeführt, sodass der Leiterplattenanschlag 21 an der Oberfläche der ersten Leiterplatte 2 anliegt. Das Abstandselement 5 ist mithilfe des Lötmittels 23 mit der ersten Leiterplatte 2 verlötet.

Die Befestigungsvorrichtung 1 ermöglicht eine stabile beabstandete Verbindung der Leiterplatten 2, 3. Die Befestigungsvorrichtung 1 ist zweiteilig aus dem Abstandselement 5 und dem Befestigungselement 4 gebildet. Der zweiteilige Aufbau der Befestigungsvorrichtung 1 hat zum einen den Vorteil, dass das metallische Abstandselement 5 durch Verlöten stabil mit der ersten Leiterplatte 2 verbunden werden kann, wobei gleichzeitig aufgrund des aus Kunststoffmaterial gefertigten Befestigungselements 4 eine elektrische Isolierung zwischen den Leiterplatten 2, 3 gewährleistet ist. Ein weiterer Vorteil des zweiteiligen Aufbaus ist, dass die Befestigungsvorrichtung 1 einfach an einen gewünschten Abstand der Leiterplatten 2, 3 angepasst werden kann. Wie aus Fig. 1 ersichtlich ist, wird der Abstand der Leiterplatten 2, 3 in Richtung der Mittellängsachse 6 im Wesentlichen durch die Länge L des Hülsenkörpers 13 des Abstandselements 5 bestimmt. Die Befestigungsvorrichtung 1 kann daher auf einfache Weise durch die Wahl eines Abstandselements 5 mit geeigneter Länge L des Hülsenkörpers 13 an den jeweiligen Anwendungsfall angepasst werden.

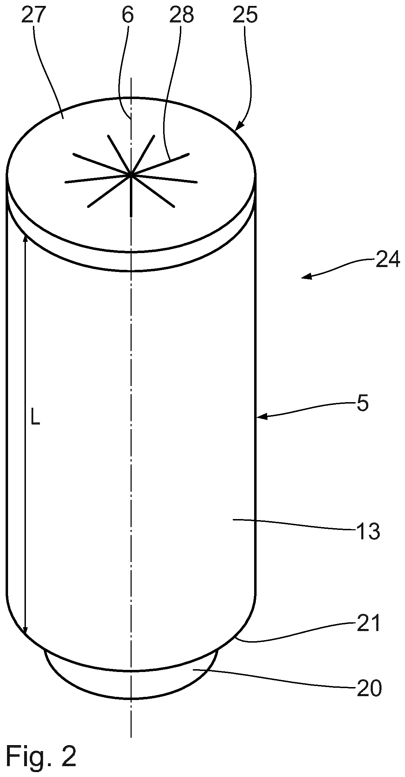

Um die oben genannten Vorteile zu realisieren, werden das Befestigungselement 4 und das Abstandselement 5 getrennt voneinander als zweiteilige Montagebaugruppe bereitgestellt. Die Montagebaugruppe weist das Befestigungselement 4 und eine Montageeinheit mit dem Abstandselement 5 auf. Eine beispielhafte Montageeinheit 24 wird anhand der Fig. 2 bis 4 erläutert. Die Montageeinheit 24 weist das Abstandselement 5 auf. Die in der Fig. 2 gezeigte Montageeinheit 24 eignet sich zum Einsatz in einer Befestigungsvorrichtung, die der Befestigungsvorrichtung 1 gemäß Fig. 1 entspricht. Das Abstandselement 5 der Montageeinheit 24 unterscheidet sich von dem Abstandselement 5 gemäß Fig. 1 lediglich in der Länge L des Hülsenkörpers 13.

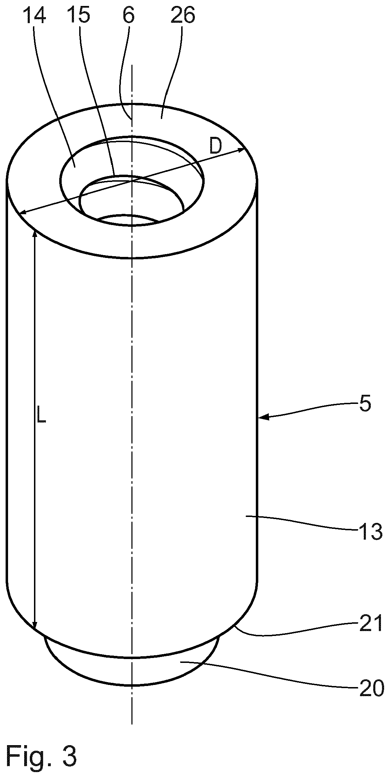

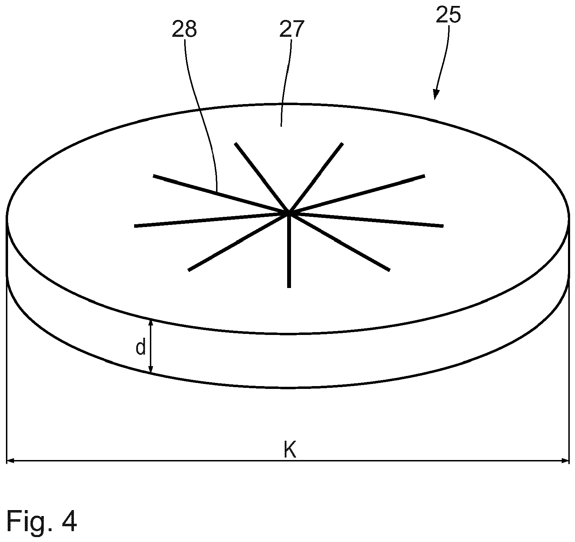

Neben dem Abstandselement 5 umfasst die Montageeinheit 24 ein auf dem Abstandselement 5 befestigtes Abdeckelement 25. Das Abdeckelement 25 ist stirnseitig auf dem Abstandselement 5 an dessen dem Einführabschnitt 20 gegenüberliegenden Ende angeordnet. Im Bereich der Aufnahmeöffnung 14 weist das Abstandselement 5 eine Querschnittsfläche 26 auf (vgl. Fig. 3). Die Querschnittsfläche 26 ist senkrecht zu der Mittellängsachse 6. Die Querschnittsfläche 26 entspricht der kreisförmigen Grundfläche des Hülsenkörpers 13 und wird durch dessen Durchmesser D definiert. Das Abdeckelement 25 ist kreisförmig und weist einen Kreisdurchmesser K auf (vgl. Fig. 4), der dem Durchmesser D entspricht. Das Abdeckelement 25 liegt daher innerhalb der Querschnittsfläche 26. Dies bedeutet, dass das Abdeckelement 25 nicht über die Querschnittsfläche 26 übersteht. Eine Querschnittsfläche der Montageeinheit 24 ist durch den Durchmesser D der Querschnittsfläche 26 beschränkt.

Das Abdeckelement 25 ist als flächige Klebefolie auf dem Abstandselement 5 aufgeklebt. Das Abdeckelement 25 weist eine Polyimid-Folie auf. Zusätzlich weist das Abdeckelement 25 eine nicht eigens dargestellte Klebeschicht auf. Das Abdeckelement 25 weist insgesamt eine Dicke zwischen 0,03 mm und 1 mm, insbesondere zwischen 0,05 mm und 0,5 mm auf.

Das Abdeckelement 25 überdeckt die Aufnahmeöffnung 14 an dem dem Einführabschnitt 20 gegenüberliegenden Ende des Abstandselements 5 vollständig. Die Aufnahmeöffnung 14 behindert die Handhabung der Montageeinheit 24 daher nicht. Eine freiliegende Oberfläche 27 des Abdeckelements 25 bildet eine Montagefläche aus, an der die Montageeinheit 24 und damit das Abstandselement 5 gehalten werden kann. Das Halten erfolgt pneumatisch, wobei das Abdeckelement 25 als Ansaugfolie dient.

Im Bereich der Aufnahmeöffnung 14 weist das Abdeckelement 25 Sollbruchstellen 28 auf. Die Sollbruchstellen 28 sind als sternförmig angeordnete Kerben in das Abdeckelement 25 eingebracht. Die Sollbruchstellen 28 sind ohne Materialabtrag in die Oberfläche 27 des Abdeckelements 25 geritzt. Die Sollbruchstellen 28 ermöglichen ein einfaches Durchbrechen des Abdeckelements 25 beim Einbringen des ersten Befestigungsabschnitts 7 des Befestigungselements 4. In der Fig. 1 sind zwischen dem Befestigungselement 4 und dem Abstandselement 5 noch die Überreste des Abdeckelements 25 zu sehen. Auf der Innenseite der Aufnahmeöffnung 14 sind beim Durchbrechen entstandene Folienfragmente 29 des Abdeckelements 25 innerhalb der Aufnahmeöffnung 14 gelagert. Ein Ablösen des Abdeckelements 25 zum Verbinden des Befestigungselements 4 mit dem Abstandselement 5 ist nicht nötig. Zudem ist konsequent verhindert, dass sich das Abdeckelement 25 oder beim Durchbrechen entstandene Folienfragmente 29 unbeabsichtigt von dem Abstandselement 5 lösen.

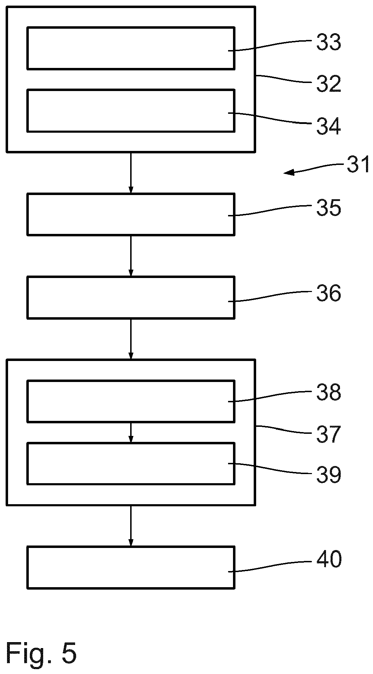

Mit Bezug auf die Fig. 5 wird ein Verbindungsverfahren 31 zum beabstandeten Verbinden von Leiterplatten beschrieben.

Zunächst wird in einem Bereitstellungsschritt die erste Leiterplatte 2 und die zweite Leiterplatte 3 sowie eine mindestens eine Montagebaugruppe mit je einem Befestigungselement 4 und je einer Montageeinheit 24 bereitgestellt. Die Länge L jedes Hülsenkörpers 13 ist an den zu erzielenden Abstand zwischen den zu verbindenden Leiterplatten 2, 3 angepasst. Die einzelnen Schritte des Verfahrens werden für die einzelnen Montagebaugruppen unabhängig voneinander durchgeführt. Daher werden die Verfahrensschritte im Folgenden nur für eine einzelne Montagebaugruppe erläutert. Die Verfahrensschritte werden für die restlichen Montagebaugruppen entsprechend durchgeführt.

Die Montageeinheit 24 aus dem Abdeckelement 25 und dem Abstandselement 5 wird in der Regel als vormontierte Einheit bereitgestellt. In einigen Ausführungsbeispielen kann jedoch auch ein Fertigungsschritt 33 als Teil des Bereitstellungsschritts 32 vorgesehen sein. In dem Fertigungsschritt 33 wird das als Klebefolie ausgeführte Abdeckelement 25 auf das Abstandselement 5 aufgeklebt. Zudem ist in einigen Ausführungsbeispielen vorgesehen, dass die Sollbruchstellen 28 vor oder nach dem Aufkleben auf das Abstandselements 5 erzeugt werden. Die Sollbruchstellen 28 werden beispielsweise durch Ritzen und/oder Materialabtrag, beispielsweise mittels Laserabtragung, in das Abdeckelement 25 eingebracht.

Auch die Leiterplatten 2, 3 werden in der Regel montagefertig bereitgestellt. Einige Ausführungsbeispiele umfassen jedoch auch einen Vorbereitungsschritt 34, in dem die Leiterplatten 2, 3 für die Montage vorbereitet werden. Hierfür werden je Befestigungsvorrichtung 1 die entsprechenden Bohrungen 12, 22 in die zweite Leiterplatte 3 bzw. die erste Leiterplatte 2 eingebracht.

An den Bereitstellungsschritt 32 schließt sich ein Montageschritt 35 an. In dem Montageschritt 35 wird die Montageeinheit 24 an der Montagefläche 27 pneumatisch mithilfe einer Montagevorrichtung gehalten und an den entsprechenden Stellen der ersten Leiterplatte 2 positioniert. Die Bestimmung der Position der Montageeinheit 24 in Bezug auf die erste Leiterplatte 2 erfolgt automatisch und wird durch geeignete Kameras visuell überprüft. Die Positionierung ist dadurch verbessert, dass das Abdeckelement 25 nicht über das Abstandselement 5 hinaussteht und somit eine visuelle Kontrolle der aktuellen Position des Abstandselements 5 nicht behindert.

Die Montageeinheit 24 und damit das Abstandselement 5 wird in dem Montageschritt 35 auch an der ersten Leiterplatte 2 befestigt. Hierfür wird zunächst der Einführabschnitt 20 in die hierfür vorgesehene Aufnahmebohrung 22 eingesteckt, bis der Leiterplattenanschlag 21 an der Oberfläche der ersten Leiterplatte 2 anliegt. Hieraufhin wird das Abstandselement 5 mit der Leiterplatte 2 mithilfe des Lötmittels 23 verlötet. Nach erfolgter Befestigung der Montageeinheit 24 an der ersten Leiterplatte 2 wird die Montagevorrichtung von der Montagefläche 27 getrennt.

Der Montageschritt 35 wird für jede der bereitgestellten Montageeinheiten 24 durchgeführt. Dies erfolgt die einzelnen Montageeinheiten 24 sequenziell. In einigen Ausführungsbeispielen kann der Montageschritt 35 für mehrere Montageeinheiten 24 parallel durchgeführt werden. Hierfür können beispielsweise mehrere Montagevorrichtungen vorgesehen sein.

Nach Abschluss des Montageschritts 35 folgt ein Kontrollschritt 36. In dem Kontrollschritt 36 wird die Positionierung und Befestigung der Montageeinheit 24 an der ersten Leiterplatte 2 kontrolliert. Der Kontrollschritt 36 wird visuell durchgeführt. Auch die Genauigkeit des Kontrollschritts 36 ist dadurch erhöht, dass das Abdeckelement 25 eine visuelle Überprüfung der Positionierung und Befestigung der Abstandselemente 5 nicht behindert.

An dem Kontrollschritt 36 schließt sich eine Verbindungsschritt 37 an. In dem Verbindungsschritt 37 wird das Befestigungselement 4 mit dem jeweiligen Abstandselement 5 verbunden. Hierzu wird zunächst in einem Durchbrechungsschritt 38 das Abdeckelement 25 im Bereich der Aufnahmeöffnung 14 durchbrochen. Dies geschieht, indem die Tragzapfen-Spitze 18 des ersten Befestigungsabschnitts 7 das Abdeckelement 25 im Bereich der Sollbruchstellen 28 durchstößt. Nach dem Durchbrechungsschritt 38 wird in einem Einbringungsschritt 39 der gesamte erste Befestigungsabschnitt 7 des Befestigungselements in die Aufnahmeöffnung 14 eingebracht. Hierbei verrasten die Tragzapfen-Rastvorsprünge 19 mit dem Innengewinde 15 der Aufnahmeöffnung 14. Beim Durchbrechen des Abdeckelements 25 entstehende Folienfragmente 29 legen sich an die Innenseite der Aufnahmeöffnung 14, sodass ein Einbringen und Verrasten des ersten Befestigungsabschnitts 7 in die Aufnahmeöffnung 14 nicht behindert ist.

In einem anschließenden Aufbringungsschritt 40 wird die zweite Leiterplatte 3 aufgebracht, indem der zweite Befestigungsabschnitt 8 mit der zweiten Leiterplatte 3 verrastet. Hierzu wird der widerhakenförmige Rastvorsprung 11 durch die Bohrung 12 geführt, sodass der zylinderförmige Grundkörper 10 innerhalb der Bohrung 12 zu liegen kommt. Die Leiterplatte 3 wird zwischen dem Rastvorsprung 11 und dem Mittelabschnitt 9 gehalten.

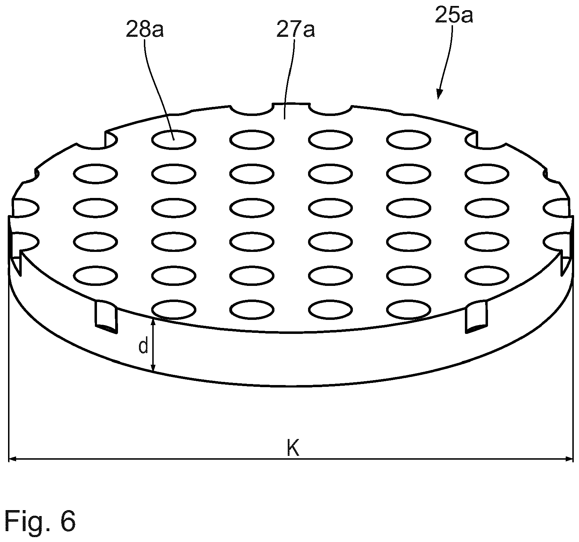

In Fig. 6 ist ein weiteres Ausführungsbeispiel eines Abdeckelements 25a gezeigt. Komponenten, die im Zusammenhang mit dem Ausführungsbeispiel in den Fig. 1 bis 4 bereits beschrieben wurden, tragen die gleichen Bezugszeichen. Konstruktiv unterschiedliche, jedoch funktional gleiche Komponenten tragen das gleiche Bezugszeichen mit einem nachgestellten a.

Das Abdeckelement 25a ist wie das Abdeckelement 25 als Polyimid-Klebefolie ausgeführt. Das Abdeckelement 25a weist eine Vielzahl periodisch angeordneter Sollbruchstellen 28a auf. Die Sollbruchstellen 28a sind an den Kreuzungspunkten eines gedachten Rechteckgitters angeordnet. Die Sollbruchstellen 28a sind jeweils als kreisförmige Vertiefungen in die Montagefläche 27a eingebracht. Das Einbringen der Sollbruchstellen 28a erfolgt mithilfe eines Lasers. Aufgrund des Materialabtrags weist das Abdeckelement 25a im Bereich der Sollbruchstellen 28a eine verringerte Dicke auf, was das Durchbrechen des Abdeckelements 25a in dem Durchbrechungsschritt 38 vereinfacht.

Ein weiteres, nicht dargestelltes Ausführungsbeispiel eines Abdeckelements entspricht im Wesentlichen dem Abdeckelement 25a. Die Sollbruchstellen sind jedoch nicht durch Materialabtrag, sondern lediglich durch Einstechen an den entsprechenden Gitterpunkten realisiert.

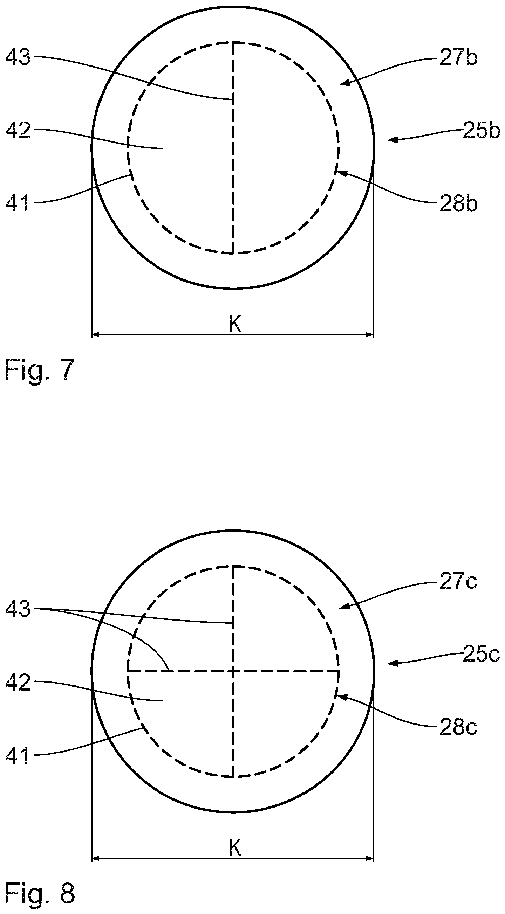

In Fig. 7 ist ein weiteres Ausführungsheispiel eines Abdeckelements 25b für das Abstandselement 5 gezeigt. Komponenten, die im Zusammenhang mit dem Ausführungsbeispiel in den Fig. 1 bis 4 bereits beschrieben wurden, tragen die gleichen Bezugszeichen. Konstruktiv unterschiedliche, jedoch funktional gleiche Komponenten tragen das gleiche Bezugszeichen mit einem nachgestellten b.

Das Abdeckelement 25b entspricht bis auf die Ausgestaltung der Sollbruchstellen 28b dem Abdeckelement 25. Bei dem Abdeckelement 25b sind die Sollbruchstellen 28b in Form einer Perforierung des Abdeckelements 25b ausgeführt. Die Perforierung kann auf einfache Weise eingebracht werden, indem beispielsweise das Abdeckelement 25b mit einer geeigneten Perforiervorrichtung perforiert wird.

Die Sollbruchstellen 28b zeichnen sich dadurch aus, dass sie an die Geometrie des Abdeckelements 25b sowie die Geometrie der Aufnahmeöffnung 14 angepasst sind. Die Aufnahmeöffnung 14 weist einen kreisförmigen Querschnitt auf. Die Sollbruchstellen 28b weisen eine kreisförmige Perforierung 41 auf, die eine dem Querschnitt der Aufnahmeöffnung 14 entsprechende Kreisfläche 42 umschließt. Die Kreisfläche 42 ist durch eine dem Mittelpunkt des entsprechenden Kreises durchlaufende Perforierlinie 43 in zwei gleich große Kreissegmente unterteilt. Diese Geometrie der Sollbruchstellen 28b gewährleistet ein zuverlässiges Durchbrechen des Abdeckelements 25b im Bereich der Aufnahmeöffnung 14, ohne dass das Abdeckelement 25b auch in dessen Randbereichen durchreißt. Ein unvorteilhaftes Ablösen des Abdeckelements 25b bei dessen Durchbrechung ist daher konsequent vermieden. Gleichzeitig wird die gesamte Aufnahmeöffnung 14 für das Einbringen des ersten Befestigungsabschnitts 7 zuverlässig freigegeben.

In Fig. 8 ist eine Aufsicht auf ein weiteres Ausführungsbeispiel eines Abdeckelements 25c gezeigt. Komponenten, die im Zusammenhang mit dem Ausführungsbeispiel in Fig. 7 bereits beschrieben wurden, tragen die gleichen Bezugszeichen. Konstruktiv unterschiedliche, jedoch funktional gleiche Komponenten tragen das gleiche Bezugszeichen mit einem nachgestellten c.

Das Abdeckelement 25c entspricht weitestgehend dem Abdeckelement 25b. Die Sollbruchstellen 28c weisen zwei senkrecht aufeinander stehende Perforierlinien 43 auf. Hierdurch wird die Kreisfläche 42 in vier gleich große Kreissektoren unterteilt. Das Reißen des Abdeckelements 25c beim Durchbrechen desselben lässt sich hierdurch noch genauer und gezielter steuern.

In wiederum anderen, nicht gezeigten Ausführungsbeispielen weist das Abdeckelement keine dedizierten Sollbruchstellen auf. In einigen Ausführungsbeispielen weisen diese Abdeckelemente eine dünne Dicke d, sodass ein Durchbrechen des Abdeckelements auch ohne das Vorsehen von Sollbruchstellen auf einfache Weise möglich ist. In wiederum anderen Ausführungsbeispielen weisen die Abdeckelemente ohne Sollbruchstellen eine erhöhte Stabilität auf. Dies vereinfacht die Fertigung und das Handling der Montageeinheit. Gegebenenfalls muss das Durchbrechen mithilfe eines separaten Durchbrechungsschritts vor dem Verbindungsschritt erfolgen. Das Durchbrechen kann beispielsweise mithilfe einer Perforiervorrichtung erfolgen.

In weiteren, nicht dargestellten Ausführungsbeispielen kann das Abdeckelement magnetische Partikel umfassen. Dies ermöglicht ein Halten der Montageeinheit 24 und damit des Abstandselements 5 im Montageschritt 35 mit magnetischen Mitteln.

In weitern, nicht dargestellten Ausführungsbeispielen entspricht der Kreisdurchmesser des Abdeckelements nicht dem Durchmesser des Abstandselements im Bereich der Aufnahmeöffnung. Beispielsweise beträgt der Kreisdurchmesser des Abdeckelements zwischen 85 % und 95 % des Durchmessers der Querschnittsfläche des Abstandselements. Auf diese Weise ist sichergestellt, dass das Abdeckelement nicht über die Querschnittsfläche des Abstandselements übersteht. Gleichzeitig wird die Aufnahmeöffnung vollständig abgedeckt, sodass die Aufnahmeöffnung eine Montage nicht behindert. Zudem ist ein Verschmutzen der Aufnahmeöffnung vermieden.

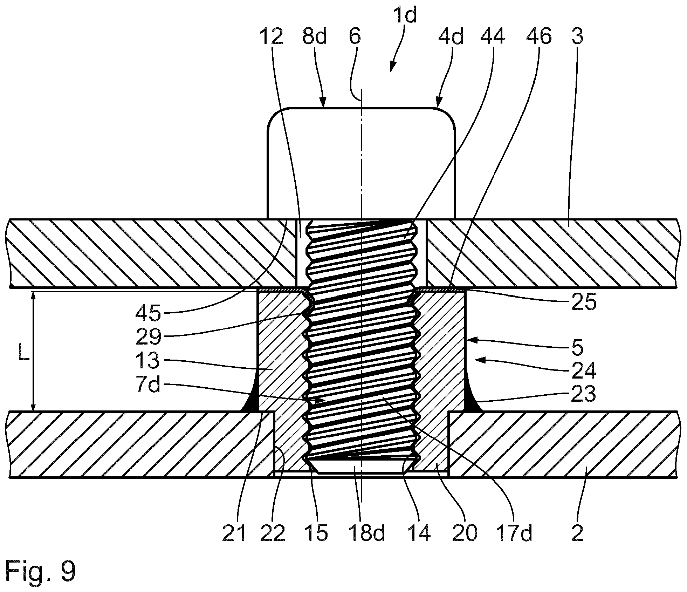

In Fig. 9 ist ein Schnitt durch ein weiteres Ausführungsbeispiel einer Befestigungsvorrichtung 1d gezeigt, über die die erste Leiterplatte 2 beabstandet mit der zweiten Leiterplatte 3 verbunden ist. Komponenten, die im Zusammenhang mit dem Ausführungsbeispiel in den Fig. 1 bis 4 bereits beschrieben wurden, tragen die gleichen Bezugszeichen. Konstruktiv unterschiedliche, jedoch funktional gleiche Komponenten tragen das gleiche Bezugszeichen mit einem nachgestellten d.

Die Befestigungsvorrichtung 1d unterscheidet sich von der Befestigungsvorrichtung 1 nur durch die Ausgestaltung des Befestigungselements 4d. Die Leiterplatten 2, 3 sowie die Montageeinheit 24 aus dem Abstandselement 5 und dem Abdeckelement 25 sind unverändert.

Das Befestigungselement 4d ist als Schraube ausgeführt. Das Befestigungselement 4d ist einstückig aus Metall gefertigt. Der erste Befestigungsabschnitt 7d weist ein Schraubengewinde 44 an einem sich entlang der Mittellängsachse 6 erstreckenden Tragzapfen-Grundkörper 17d auf. Der zweite Befestigungsabschnitt 8d ist als Schraubenkopf ausgeführt.

Das Schraubengewinde 44 korrespondiert mit dem Gewinde 15 der Aufnahmeöffnung 14 des Abstandselements 5. Der erste Befestigungsabschnitt 7d kann daher nach Durchbrechen des Abdeckelements 25 in die Aufnahmeöffnung 14 eingeschraubt werden und wird hierdurch fest und zuverlässig mit dieser verbunden. Das als Schraube ausgeführte Befestigungselement 4d wird hierbei von oben über die Bohrung 12 durch die zweite Leiterplatte 3 in die Aufnahmeöffnung 14 eingeschraubt. Der erste Befestigungsabschnitt 7d mit dem Schraubengewinde 44 erstreckt sich daher auch durch die Bohrung 12 der zweiten Leiterplatte 3.

Der als Schraubenkopf ausgeführte zweite Befestigungsabschnitt 8d weist der zweiten Leiterplatte 3 zugewandte Halteflächen 45 auf. Nach Einschrauben des Schraubengewindes 44 in die Aufnahmeöffnung 14 liegen die Halteflächen 45 auf der Leiterplatte 3 auf und halten diese gegen die dem Befestigungselement 4d zugewandte Stirnseite 46 der Montageeinheit 24.

Wie oben bereits beschrieben, wird die Leiterplatte 3 bei der Befestigungsvorrichtung 1d zwischen der Stirnseite 46 und den Halteflächen 45 des zweiten Befestigungsabschnitts 8d gehalten. Dementsprechend weist das Befestigungselement 4d keinen zwischen den Befestigungsabschnitten 7d, 8d angeordneten Mittelabschnitt auf. Die beiden Leiterplatten 2, 3 sind daher bei der Befestigungsvorrichtung 1d im Wesentlichen um die Länge L des Hülsenkörpers 13 des Abstandselements 5 beabstandet.

Werden die beiden Leiterplatten 2, 3 mit der Befestigungsvorrichtung 1d verbunden, muss das Verbindungsverfahren 31 hierfür geringfügig angepasst werden. Nach dem Positionieren und Befestigen aller Montageeinheiten in den Montageschritt 35 und der anschließenden Kontrolle im Kontrollschritt 36 wird die zweite Leiterplatte 3 zunächst auf die Stirnseite 46 der Montageeinheit 24 aufgelegt. Hierbei ist darauf zu achten, dass die Bohrung 12 oberhalb der Aufnahmeöffnung 14 zu liegen kommt. Anschließend wird das Befestigungselement 4d mit dem Schraubengewinde 44 durch die Bohrung 12 geführt und durchbricht das Abdeckelement 25. Das Schraubengewinde 44 wird in das Gewinde 15 der Aufnahmeöffnung 14 eingeschraubt, bis die Halteflächen 45 des zweiten Befestigungsabschnitts 8d auf der Leiterplatte 3 aufliegen und diese gegen die Stirnseite 46 halten.

In weiteren, nicht dargestellten Ausführungsformen können auch mehrere Montageeinheiten, insbesondere mehrere Abstandselemente mit einem einzigen Befestigungselement zu einer Befestigungsvorrichtung verbunden werden, um mehrere Leiterplatten beabstandet miteinander zu verbinden. Sollen beispielsweise N Leiterplatten miteinander verbunden werden, werden (N-1) Montageeinheiten benötigt. Zunächst wird auf der ersten Leiterplatte eine erste Montageeinheit positioniert und befestigt. Anschließend wird die zweite Leiterplatte auf die der ersten Leiterplatte gegenüberliegende Stirnseite der ersten Montageeinheit aufgelegt. Hierbei wird eine Bohrung der zweiten Leiterplatte oberhalb der Aufnahmeöffnung des ersten Abstandselements positioniert. Anschließend wird eine zweite Montageeinheit auf der zweiten Leiterplatte direkt oberhalb des ersten Abstandselements positioniert und eine weitere Leiterplatte aufgebracht. Dies wird wiederholt, bis alle Leiterplatten jeweils paarweise über eine Montageeinheit beabstandet aufeinander gestapelt sind. Anschließend wird ein Befestigungselement, das als Schraube ausgeführt sein kann, von oben durch die oberste Leiterplatte in die Aufnahmeöffnungen der darunter liegenden Abstandselemente eingeführt, wobei die jeweiligen Abdeckelemente durchbrochen werden. Hierbei kann vorgesehen sein, dass der erste Befestigungsabschnitt des Befestigungselements durch die oberen Abstandselemente lose geführt wird und nur im untersten Abdeckelement verankert wird. Alternativ kann eine formschlüssige Verbindung zwischen dem ersten Befestigungsabschnitt und jedem der Abstandselemente, beispielsweise durch miteinander korrespondierende Gewinden, realisiert sein.

## Patentansprüche

1. Verfahren zum beabstandeten Verbinden von Leiterplatten mit den Schritten:
- Bereitstellen
-- mindestens einer Montageeinheit (24) mit
--- einem eine Aufnahmeöffnung (14) aufweisenden Abstandselement (5) und
--- einem Abdeckelement (25; 25a; 25b; 25c), das die Aufnahmeöffnung (14) abdeckt,
-- eines Befestigungselements (4; 4d) je Montageeinheit (24),
-- einer ersten Leiterplatte (2) und
-- einer mit der ersten Leiterplatte (2) zu verbindenden zweiten Leiterplatte (3),
- Positionieren und Befestigen des Abstandselements (5) an der ersten Leiterplatte (2),
- Durchbrechen des Abdeckelements (25; 25a; 25b; 25c) im Bereich der Aufnahmeöffnung (14),
- Einbringen des Befestigungselements (4; 4d) in die Aufnahmeöffnung (14), und
- Verbinden der zweiten Leiterplatte (3) mit der ersten Leiterplatte (2) mittels des Befestigungselements (4; 4d).

2. Verfahren nach Anspruch 1, **dadurch gekennzeichnet, dass** das Abdeckelement (25; 25a; 25b; 25c) im Bereich der Aufnahmeöffnung (14) mithilfe des Befestigungselements (4; 4d) durchbrochen wird.

3. Verfahren nach einem der vorgenannten Ansprüche, **dadurch gekennzeichnet, dass** die Montageeinheit (24) zur Positionierung und Befestigung des Abstandselements (5) an der ersten Leiterplatte (2) mittels einer Montagevorrichtung an dem Abdeckelement (25; 25a; 25b; 25c) gehalten, bevorzugt pneumatisch gehalten, wird.

4. Verfahren nach einem der vorgenannten Ansprüche, **dadurch gekennzeichnet, dass** das Abstandselement (5) mit der ersten Leiterplatte (2) verlötet wird.

5. Verfahren nach einem der vorgenannten Ansprüche, **dadurch gekennzeichnet, dass** das Abdeckelement (25; 25a; 25b; 25c) innerhalb einer im Bereich der Aufnahmeöffnung (14) gemessenen Querschnittsfläche (26) des Abstandselements (5) liegt.

6. Verfahren nach einem der vorgenannten Ansprüche, **dadurch gekennzeichnet, dass** das Abdeckelement (25; 25a; 25b; 25c) als Folie, insbesondere Klebefolie, auf dem Abstandselement (5) aufgebracht ist.

7. Verfahren nach einem der vorgenannten Ansprüche, **dadurch gekennzeichnet, dass** das Abdeckelement (25; 25a; 25b; 25c) mindestens eine Sollbruchstelle (28; 28a; 28b; 28c) im Bereich der Aufnahmeöffnung (14) aufweist, wobei die mindestens eine Sollbruchstelle (28; 28a; 28b; 28c) insbesondere als Kerbung und/oder Perforierung des Abdeckelements (25; 25a; 25b; 25c) ausgeführt ist.

8. Verfahren nach einem der vorgenannten Ansprüche, **gekennzeichnet durch** einen Kontrollschritt (36) zur Kontrolle der Positionierung und/oder Befestigung des Abstandselements (5) an der ersten Leiterplatte (2).

9. Montageeinheit für das beabstandete Verbinden zweier Leiterplatten, aufweisend
- ein Abstandselement (5) mit einer Aufnahmeöffnung (14) zur Aufnahme eines Befestigungselements (4; 4d),
**gekennzeichnet durch**
ein Abdeckelement (25; 25a; 25b; 25c), das die Aufnahmeöffnung (14) abdeckt.

10. Montageeinheit nach Anspruch 9, **dadurch gekennzeichnet, dass** das Abdeckelement (25; 25a; 25b; 25c) als Folie, insbesondere Klebefolie, ausgebildet ist.

11. Montageeinheit nach einem der Ansprüche 9 oder 10, **dadurch gekennzeichnet, dass** das Abdeckelement (25; 25a; 25b; 25c) eine Dicke (d) zwischen 0,03 mm und 1 mm, insbesondere zwischen 0,05 mm und 0,5 mm aufweist.

12. Montageeinheit nach einem der Ansprüche 9 bis 11, **dadurch gekennzeichnet, dass** das Abdeckelement (25; 25a; 25b; 25c) mindestens eine Sollbruchstelle (28; 28a; 28b; 28c) im Bereich der Aufnahmeöffnung (14) aufweist, wobei die mindestens eine Sollbruchstelle (28; 28a; 28b; 28c) insbesondere als Kerbung und/oder Perforierung des Abdeckelements (25) ausgeführt ist.

13. Montageeinheit nach einem der Ansprüche 9 bis 12, **dadurch gekennzeichnet, dass** das Abdeckelement (25; 25a; 25b; 25c) innerhalb einer im Bereich der Aufnahmeöffnung (14) gemessenen Querschnittsfläche (26) des Abstandselements (5) liegt.

14. Montageeinheit nach einem der Ansprüche 9 bis 13, **dadurch gekennzeichnet, dass** das Abstandselement (5) einstückig aus einem Metall gefertigt ist.

15. Montagebaugruppe für das beabstandete Verbinden zweier Leiterplatten, aufweisend
- eine Montageeinheit (24) nach mindestens einem der Ansprüche 9 bis 14, und
- ein Befestigungselement (4; 4d).

## Claims

1. Method for the spaced connection of printed circuit boards including the steps:
- providing
-- at least one installation unit (24) comprising
--- a distance element (5) having an intake opening (14) and
--- a cover element (25; 25a; 25b; 25c), which covers the intake opening (14),
-- a fixing element (4; 4d) per installation unit (24),
-- a first printed circuit board (2) and
-- a second printed circuit board (3) to be connected with the first printed circuit board (2),
- positioning and fixing the distance element (5) on the first printed circuit board (2),
- penetrating the cover element (25; 25a; 25b; 25c) in the region of the intake opening (14),
- inserting the fixing element (4; 4d) into the intake opening (14), and
- connecting the second printed circuit board (3) with the first printed circuit board (2) by means of the fixing element (4; 4d).

2. Method according to claim 1, **characterized in that** the cover element (25; 25a; 25b; 25c) is penetrated in the region of the intake opening (14) with the help of the fixing element (4; 4d).

3. Method according to any one of the preceding claims, **characterized in that** the installation unit (24), for the positioning and fixing of the distance element (5) on the first printed circuit board (2), is held, preferably held pneumatically, on the cover element (25; 25a; 25b; 25c) by means of an installation device.

4. Method according to any one of the preceding claims, **characterized in that** the distance element (5) is soldered with the first printed circuit board (2).

5. Method according to any one of the preceding claims, **characterized in that** the cover element (25; 25a; 25b; 25c) is located within a cross-sectional surface (26) of the distance element (5), measured in the region of the intake opening (14).

6. Method according to any one of the preceding claims, **characterized in that** the cover element (25; 25a; 25b; 25c) is applied onto the distance element (5) as a foil, in particular an adhesive foil.

7. Method according to any one of the preceding claims, **characterized in that** the cover element (25; 25a; 25b; 25c) has at least one predetermined breaking point (28; 28a; 28b; 28c) in the region of the intake opening (14), wherein the at least one predetermined breaking point (28; 28a; 28b; 28c) is configured in particular as a notch and/or perforation of the cover element (25; 25a; 25b; 25c).

8. Method according to any one of the preceding claims, **characterized by** a control step (36) for the control of the positioning and/or the fixing of the distance element (5) on the first printed circuit board (2).

9. Installation unit for the spaced connection of two printed circuit boards, having
- a distance element (5) including an intake opening (14) for receiving a fixing element (4; 4d), **characterized by** a cover element (25; 25a; 25b; 25c), which covers the intake opening (14).

10. Installation unit according to claim 9, **characterized in that** the cover element (25; 25a; 25b; 25c) is configured as a foil, in particular as an adhesive foil.

11. Installation unit according to any one of claims 9 or 10, **characterized in that** the cover element (25; 25a; 25b; 25c) has a thickness (d) between 0.03 mm and 1 mm, in particular between 0.05 mm and 0.5 mm.

12. Installation unit according to any one of the claims 9 to 11, **characterized in that** the cover element (25; 25a; 25b; 25c) has at least one predetermined breaking point (28; 28a; 28b; 28c) in the region of the intake opening (14), wherein the at least one predetermined breaking point (28; 28a; 28b; 28c) is configured in particular as a notch and/or perforation of the cover element (25).

13. Installation unit according to any one of the claims 9 to 12, **characterized in that** the cover element (25; 25a; 25b; 25c) is located within a cross-sectional surface (26) of the distance element (5), measured in the region of the intake opening (14).

14. Installation unit according to any one of the claims 9 to 13, **characterized in that** the distance element (5) is made of metal in one piece.

15. Installation assembly for the spaced connection of two printed circuit boards, having
- an installation unit (24) according to at least one of claims 9 to 14, and
- a fixing element (4; 4d).

## Revendications

1. Procédé de raccordement espacé de cartes de circuit imprimé avec les étapes :
- de fourniture
-- d'au moins une unité de montage (24) avec
--- un élément d'espacement (5) présentant une ouverture de réception (14) et
--- un élément de recouvrement (25 ; 25a ; 25b ; 25c) qui recouvre l'ouverture de réception (14),
-- d'un élément de fixation (4 ; 4d) par unité de montage (24),
-- d'une première carte de circuit imprimé (2) et
-- d'une seconde carte de circuit imprimé (3) à raccorder à la première carte de circuit imprimé (2),
- de positionnement et de fixation de l'élément d'espacement (5) au niveau de la première carte de circuit imprimé (2),
- de percement de l'élément de recouvrement (25 ; 25a ; 25b ; 25c) dans la zone de l'ouverture de réception (14),
- de pose de l'élément de fixation (4 ; 4d) dans l'ouverture de réception (14), et
- de raccordement de la seconde carte de circuit imprimé (3) à la première carte de circuit imprimé (2) au moyen de l'élément de fixation (4 ; 4d).

2. Procédé selon la revendication 1, **caractérisé en ce que** l'élément de recouvrement (25 ; 25a ; 25b ; 25c) est percé dans la zone de l'ouverture de réception (14) à l'aide de l'élément de fixation (4 ; 4d).

3. Procédé selon l'une quelconque des revendications susmentionnées, **caractérisé en ce que** l'unité de montage (24) pour le positionnement et la fixation de l'élément d'espacement (5) au niveau de la première carte de circuit imprimé (2) est maintenue, de préférence maintenue de manière pneumatique, au moyen d'un dispositif de montage au niveau de l'élément de recouvrement (25 ; 25a ; 25b ; 25c).

4. Procédé selon l'une quelconque des revendications susmentionnées, **caractérisé en ce que** l'élément d'espacement (5) est soudé à la première carte de circuit imprimé (2).

5. Procédé selon l'une quelconque des revendications susmentionnées, **caractérisé en ce que** l'élément de recouvrement (25 ; 25a ; 25b ; 25c) est situé à l'intérieur d'une surface de section transversale (26) de l'élément d'espacement (5) mesurée dans la zone de l'ouverture de réception (14).

6. Procédé selon l'une quelconque des revendications susmentionnées, **caractérisé en ce que** l'élément de recouvrement (25 ; 25a ; 25b ; 25c) est appliqué en tant que feuille, en particulier en tant que feuille adhésive, sur l'élément d'espacement (5).

7. Procédé selon l'une quelconque des revendications susmentionnées, **caractérisé en ce que** l'élément de recouvrement (25 ; 25a ; 25b ; 25c) présente au moins un point destiné à la rupture (28 ; 28a ; 28b ; 28c) dans la zone de l'ouverture de réception (14), dans lequel l'au moins un point destiné à la rupture (28 ; 28a ; 28b ; 28c) est exécuté en particulier en tant qu'entaille et/ou perforation de l'élément de recouvrement (25 ; 25a ; 25b ; 25c).

8. Procédé selon l'une quelconque des revendications susmentionnées, **caractérisé par** une étape de contrôle (36) pour le contrôle du positionnement et/ou de la fixation de l'élément d'espacement (5) au niveau de la première carte de circuit imprimé (2).

9. Unité de montage pour le raccordement de deux cartes de circuit imprimé, présentant
- un élément d'espacement (5) avec une ouverture de réception (14) pour la réception d'un élément de fixation (4 ; 4d),
**caractérisée par**
un élément de recouvrement (25 ; 25a; 25b ; 25c) qui recouvre l'ouverture de réception (14).

10. Unité de montage selon la revendication 9, **caractérisée en ce que** l'élément de recouvrement (25 ; 25a ; 25b ; 25c) est conçu en tant que feuille, en particulier en tant que feuille adhésive.

11. Unité de montage selon l'une quelconque des revendications 9 ou 10, **caractérisée en ce que** l'élément de recouvrement (25 ; 25a ; 25b ; 25c) présente une épaisseur (d) entre 0,03 mm et 1 mm, en particulier entre 0,05 mm et 0,5 mm.

12. Unité de montage selon l'une quelconque des revendications 9 à 11, **caractérisée en ce que** l'élément de recouvrement (25 ; 25a ; 25b ; 25c) présente au moins un point destiné à la rupture (28 ; 28a ; 28b ; 28c) dans la zone de l'ouverture de réception (14), dans laquelle l'au moins un point destiné à la rupture (28 ; 28a ; 28b ; 28c) est exécuté en particulier en tant qu'entaille et/ou perforation de l'élément de recouvrement (25).

13. Unité de montage selon l'une quelconque des revendications 9 à 12. **caractérisée en ce que** l'élément de recouvrement (25 ; 25a ; 25b ; 25c) est situé à l'intérieur d'une surface de section transversale (26) de l'élément d'espacement (5) mesurée dans la zone de l'ouverture de réception (14).

14. Unité de montage selon l'une quelconque des revendications 9 à 13. **caractérisée en ce que** l'élément d'espacement (5) est fabriqué d'une seule pièce faite d'un métal.

15. Groupe de montage pour le raccordement espacé de deux cartes de circuit imprimé, présentant
- une unité de montage (24) selon au moins l'une quelconque des revendications 9 à 14, et
- un élément de fixation (4 ; 4d).
